# FASCICULE DE BREVET EUROPEEN

(11) **EP 2 567 478 B1**
(45) Date de publication et mention de la délivrance du brevet: **21.05.2014**
(21) Numéro de dépôt: 11716537.3
(22) Date de dépôt: 26.04.2011
(51) Int. Cl.: H04B 17/00, G01R 29/08

(54) **SYSTEME ET PROCEDE DE SIMULATION D'ENVIRONNEMENTS ELECTROMAGNETIQUES COMPORTANT UN RESEAU D'UNE PLURALITE DE SONDES**
SYSTEM UND VERFAHREN ZUR SIMULATION ELEKTROMAGNETISCHER UMGEBUNGEN MIT EINER ANORDNUNG EINSCHLIESSLICH EINER VIELZAHL VON SONDEN
SYSTEM AND METHOD FOR SIMULATING ELECTROMAGNETIC ENVIRONMENTS COMPRISING AN ARRAY INCLUDING A PLURALITY OF PROBES

(30) Priorité: 07.05.2010 FR 1053593
(43) Date de publication de la demande: 13.03.2013
(73) Titulaire: Satimo Industries, 91140 Villebon Sur Yvette (FR)
(72) Inventeur: GROSS, Nicolas, F-91190 Gif S/Yvette (FR)
(74) Mandataire: Regimbeau
(86) Numéro de dépôt international: PCT/EP2011/056571
(87) Numéro de publication internationale: WO 2011/138190

(56) Documents cités:
- EP-A1- 2 053 764
- US-A1- 2008 056 340

## Description

L'invention concerne un système de génération d'environnements électromagnétiques comportant au moins un réseau de sondes d'émission de rayonnements électromagnétiques vers une zone de test pour tester un objet sous test situé en cette zone de test. L'objet sous test consiste en au moins une antenne. La configuration du réseau de sondes d'émission peut être transposée en configuration de réseau de sondes de réception.

Un domaine d'application du système de génération d'environnements électromagnétiques est le test de différents objets sous test comportant une ou plusieurs antennes auxquelles on peut accéder individuellement ou bien simultanément, lesdites antennes pouvant être reliées ou non à un ou plusieurs récepteurs ou émetteurs intégrés. Ces objets sous test peuvent être par exemple les téléphones portables, les appareils dits « sans fils » ou tout autre dispositif antennaire pour applications civiles, aéronautiques ou militaires associé à un ou plusieurs récepteurs embarqués. Par exemple, un type de tests connu de l'homme de l'art concerne la caractérisation des appareils dits « MIMO » à entrées multiples et sorties multiples (en anglais : Multiple Input Multiple Output).

On cherche donc à pouvoir tester l'objet sous test en le soumettant à différents rayonnements électromagnétiques provenant des sondes, lesquelles sondes sont par exemple réparties angulairement autour de la zone de test.

Au moins un générateur de signal est prévu pour créer un ou plusieurs signaux Radiofréquences (signaux RF). Le générateur de signal peut être par exemple un analyseur de réseau ou un synthétiseur de fréquences générant un signal RF à des fréquences discrètes, un testeur de radiocommunication générant un signal RF modulé suivant un protocole de communication ou toute autre source de signal RF. Au moins un récepteur de signal est prévu pour recevoir un ou plusieurs signaux radiofréquences. Le récepteur de signal peut être intégré au générateur de signal comme dans le cas de l'analyseur de réseau ou du testeur de radiocommunication ou bien déporté du générateur comme dans le cas d'un récepteur associé à un synthétiseur de fréquence. Le récepteur permet de recueillir la réponse de l'objet sous test pour pouvoir ensuite l'évaluer en termes de transmission ou de qualité de communication par exemple.

Un émulateur de canaux est utilisé pour pouvoir multiplexer et transformer le ou les signaux radiofréquences issus du générateur de signaux à travers un ou plusieurs canaux. Le signal de chaque canal est transmis en mode conduit à une sonde qui le rayonne vers la zone de test. L'émulateur de canaux permet par exemple de manière indépendante pour chaque canal de faire varier la phase, l'amplitude, la fréquence et le temps de groupe du signal qui est émis par la sonde. Les sondes peuvent posséder une seule polarisation circulaire ou linéaire ou bien deux polarisations orthogonales. Afin de transmettre le signal à chaque polarisation de sonde individuellement et le cas échéant différemment des autres polarisations des autres sondes, chaque polarisation de sonde peut être associée à un canal par lequel elle reçoit le signal à émettre

Le système de test constitué du générateur et du récepteur de signaux RF, de l'émulateur de canaux et du réseau de sondes peut ainsi servir à générer des environnements électromagnétiques que peut rencontrer l'objet sous test au cours de son utilisation normale en environnement réel en dehors du test. Un tel dispositif est connu par exemple par le document US-A-2008/0056340.

D'une manière générale, il est connu que pour étalonner le système de génération de scénarios électromagnétiques, on utilise différents dipôles de réponses connues à l'avance et placés comme antennes au centre de la zone de test.

De tels dipôles présentent l'inconvénient d'être à bande étroite en fréquence, ce qui nécessite d'en utiliser un grand nombre pour réaliser l'étalonnage, et en outre d'être à polarisation unique, ce qui nécessite pour chaque bande de fréquences l'utilisation de deux dipôles de polarisations différentes au centre de la zone de test dans le cas d'un système équipé d'un réseau de sondes bipolarisées.

Au moyen des mesures ainsi réalisées avec des dipôles connus et placés au centre de la zone de test, on corrige les caractéristiques de chaque canal pour faire correspondre la réponse des dipôles à un signal de consigne prédéfinie. Cette correction a pour but principal d'uniformiser la réponse de chaque canal en terme de réponse de temps de groupe, d'amplitude et de phase depuis le générateur de signal jusqu'au dipôle. Il est aussi connu que l'homme de l'art pourra utiliser des antennes de type antennes à fentes ou boucles magnétiques par exemple à la place des dipôles, mais ces dernières possèdent des désavantages similaires à ceux des dipôles.

Par conséquent, cet étalonnage est long, compliqué, laborieux et difficile à mettre en oeuvre.

Un autre inconvénient majeur de cette technique d'étalonnage au moyen des dipôles est l'absence d'étalonnage du réseau de sondes en lui-même. En effet, la technique d'étalonnage utilisant les dipôles correspond principalement à une uniformisation des chemins de transmission entre le générateur de signaux en passant par l'émulateur de canaux et le réseau de sondes jusqu'au dipôle. Cela ne correspond en aucun cas à l'étalonnage du réseau de sondes en lui-même qui permet par exemple l'uniformisation de l'axe radioélectrique de chacune des polarisations des sondes sans laquelle on ne peut pas garantir de mesures de qualité au moyen du réseau de sondes.

Enfin, un autre inconvénient majeur de cette technique d'étalonnage au moyen des dipôles est l'instabilité intrinsèque de la correction appliquée. En effet, une fois étalonné avec cette méthode, le système de génération de scénarios électromagnétiques ne présente pas une réponse stable dans le temps, ce qui remet en cause les mesures effectuées avec les différents objets sous test pour lesquels on souhaite caractériser le comportement à des rayonnements émis par les sondes. Ceci est principalement dû au fait que l'émulateur de canal et les canaux eux-mêmes comportent des éléments hyperfréquences actifs dont les réponses varient au cours du temps et en fonction de la température par exemple. Ceci se traduit par des fluctuations au cours de la journée des réponses mesurées de l'objet sous test : le test effectué à une première heure de la journée à partir de premiers signaux avec un premier objet sous test donnera une première réponse de celui-ci et le même test effectué à une deuxième heure de la journée à partir des mêmes premiers signaux sur le même premier objet sous test pourra donner une deuxième réponse différente de la première réponse et non prédictible. Par conséquent, les tests ne sont pas reproductibles, sauf si l'étalonnage au moyen des dipôles est répété fréquemment au cours de la journée, ce qui devient très handicapant en termes de cadence de mesure. Ceci peut être aggravé par le fait que certains émulateurs de canaux nécessitent un étalonnage à chaque démarrage.

L'invention vise à obtenir un dispositif d'étalonnage simplifié et automatisable de chaque canal. Cet étalonnage de chacun des canaux est indépendant de l'étalonnage du réseau de sondes lui-même et permet de pallier les inconvénients décrits ci-dessus.

A cet effet, un premier objet de l'invention est un système de simulation d'environnements électromagnétiques, comportant :
- un réseau (200) d'une pluralité de sondes (Sᵢ) d'émission et/ou de réception de rayonnements électromagnétiques vers ou depuis un point test distant des sondes (Sᵢ) pour tester au moins une antenne test (300) située au point test,
- une multiplicité de canaux (C) de liaison des sondes à un émulateur (600) de canaux,
- une première unité (400) d'émission de signal,
- une deuxième unité (410) de réception de signal,
- l'une des première et deuxième unités (400, 410) étant reliée à l'émulateur (600) de canaux,
   caractérisé par un dispositif de commutation (100) ayant une première position de mesure, dans laquelle le dispositif de commutation (100) relie l'émulateur (600) à respectivement au moins l'une (Sᵢ) des sondes via le au moins un canal associé (C) et relie l'autre des première et deuxième unités (410, 400) à l'antenne test (300), et une deuxième position d'étalonnage des canaux (C), dans laquelle le dispositif de commutation (100) relie l'émulateur (600) à l'autre des première et deuxième unités (410, 400) via le au moins un canal associé (C) sans passer par le réseau (200) de sondes (Sᵢ), la deuxième position étant distincte de la première position.

Suivant un mode de réalisation de l'invention, l'émulateur (600) de canaux est relié à la première unité (400) d'émission de signal, le dispositif (100) de commutation dans la première position de mesure relie l'émulateur (600) à respectivement au moins l'une (Si) des sondes via le au moins un canal associé (C) et relie la deuxième unité (410) de réception de signal à l'antenne test (300), et le dispositif (100) de commutation dans la deuxième position d'étalonnage des canaux (C) relie l'émulateur (600) à la deuxième unité (410) de réception de signal via le au moins un canal associé (C) sans passer par le réseau (200) de sondes (Sᵢ).

Suivant un mode de réalisation de l'invention, l'émulateur (600) de canaux est relié à la deuxième unité (410) de réception, le dispositif (100) de commutation dans la première position de mesure relie l'émulateur (600) à respectivement au moins l'une (Si) des sondes via le au moins un canal associé (C) et relie la première unité (400) d'émission de signal de signal à l'antenne test (300), et le dispositif (100) de commutation dans la deuxième position d'étalonnage des canaux (C) relie l'émulateur (600) à la première unité (400) d'émission via le au moins un canal associé (C) sans passer par le réseau (200) de sondes (Sᵢ).

Suivant un mode de réalisation de l'invention, le dispositif de commutation (100) dans la première position de mesure relie une multiplicité d'accès (A) de l'émulateur (600) à respectivement la pluralité des sondes (Sᵢ) via la multiplicité des canaux associés (C) et relie l'autre des première et deuxième unités (410, 400) à l'antenne test (300), et le dispositif de commutation (100) dans la deuxième position d'étalonnage des canaux (C) relie la multiplicité d'accès (A) de l'émulateur (600) à l'autre des première et deuxième unités (410, 400) via la multiplicité des canaux associés (C) sans passer par le réseau (200) de sondes (Sᵢ), la deuxième position étant distincte de la première position.

Suivant un mode de réalisation de l'invention, l'émulateur de canaux 600 possède des moyens (T) de transformation contrôlables pour faire varier individuellement pour chaque canal (C) au moins l'une parmi la fréquence, la phase, l'amplitude et les polarisations du signal de chaque sonde (Sᵢ) associée.

Suivant un mode de réalisation de l'invention, le système comporte des moyens (116, 122, 135) de commande du dispositif de commutation (100) pour le faire passer entre l'une et l'autre des première et deuxième positions et pour le maintenir dans l'une quelconque des première et deuxième positions.

Suivant un mode de réalisation de l'invention, le dispositif de commutation (100) comporte des commutateurs ou analogues (11, 13) ayant lesdites positions pour assurer lesdites liaisons.

Suivant un mode de réalisation de l'invention, le système comprend une unité (700) de génération de deux première et deuxième polarisations orthogonales entre elles pour diviser le signal transporté par ledit au moins un canal (C) en deux première et deuxième voies (710) ayant respectivement les deux première et deuxième polarisations orthogonales entre elles, les deux voies étant reliées à la sonde associée (Sᵢ), des moyens de pondération étant prévus pour pondérer chacune des deux première et deuxième voies (710) en amplitude et en phase.

Suivant un mode de réalisation de l'invention, l'antenne test (300) est reliée à l'autre des première et deuxième unités (410, 400) de manière filaire par l'intermédiaire d'au moins un câble (330).

Suivant un mode de réalisation de l'invention, l'antenne test (300) est reliée sans fil à l'autre des première et deuxième unités (410, 400) par l'intermédiaire d'au moins une liaison radio avec un émetteur et/ou récepteur embarqué (320). Dans ce cas, la réception / émission se fait dans l'objet sous test et la liaison radio (RF pour radiofréquence) ne sert qu'à récupérer les valeurs utiles.

Suivant un mode de réalisation de l'invention, le dispositif de commutation (100) est placé entre l'émulateur (600) de canaux et le réseau (200) de sondes (Sᵢ).

Un autre objet de l'invention est un procédé de simulation d'environnements électromagnétiques à l'aide d'un système (1) tel que décrit ci-dessus, le système comportant un réseau (200) d'une pluralité de sondes (Si) d'émission et/ou de réception de rayonnements électromagnétiques vers ou depuis un point test distant des sondes (Sᵢ) pour tester au moins une antenne test (300) située au point test, une multiplicité de canaux (C) de liaison des sondes à un émulateur (600) de canaux, une première unité (400) d'émission de signal, une deuxième unité (410) de réception de signal, l'une des première et deuxième unités (400, 410) étant reliée à l'émulateur (600) de canaux,
caractérisé en ce que
- on place le dispositif de commutation (100) dans la deuxième position d'étalonnage des canaux (C), dans laquelle le dispositif de commutation (100) relie l'émulateur (600) à l'autre des première et deuxième unités (410, 400) via le au moins un canal associé (C) sans passer par le réseau (200) de sondes (Sᵢ),
- on acquiert dans la deuxième position d'étalonnage des canaux (C) la valeur d'un coefficient de transmission complexe sur chaque canal (C) entre la première unité (400) d'émission de signal et la deuxième unité (410) de réception de signal en passant par l'émulateur (600) de canaux sans passer par le réseau (200) de sondes (Sᵢ),
- puis on place le dispositif de commutation (100) dans la première position de mesure, dans laquelle le dispositif de commutation (100) relie l'émulateur (600) à respectivement au moins l'une (Si) des sondes via le au moins un canal associé (C) et relie l'autre des première et deuxième unités (410, 400) à l'antenne test (300),
- on teste l'antenne test (300) dans la première position de mesure en envoyant au moins un signal de la première unité (400) d'émission de signal à la deuxième unité (410) de réception de signal via ledit au moins un canal (C) par ladite au moins une sonde (Sᵢ) et en appliquant au signal une correction calculée en fonction au moins de la valeur ayant été acquise du coefficient de transmission complexe sur ledit au moins un canal (C).

Dans un mode de réalisation de l'invention, la correction est calculée en fonction au moins de la valeur ayant été acquise du coefficient de transmission complexe sur ledit au moins un canal (C) et en outre en fonction de paramètres de transmission ayant été mesurés au préalable sur le dispositif.

Dans un mode de réalisation de l'invention, une multiplicité de canaux transmettant chacun un signal issu d'un générateur de signal radiofréquence vers une sonde d'un réseau d'une pluralité de sondes d'émission de rayonnements électromagnétiques. Ce dispositif d'étalonnage est réciproque et permet d'étalonner une multiplicité de canaux transmettant chacun un signal issu d'une sonde d'un réseau d'une pluralité de sondes de réception de rayonnements électromagnétiques vers un récepteur de signal radiofréquence.

Dans des modes de réalisation, ce dispositif est caractérisé :
- en ce qu'il s'insère entre l'émulateur de canaux et le réseau de sondes,
- en ce qu'il est constitué d'un ensemble de commutateurs, de diviseurs et/ou de coupleurs ayant une première position dite de mesure permettant de relier au moins l'une des premières sorties de l'émulateur de canaux à respectivement au moins l'une des sondes du réseau via au moins un canal associé et de relier l'antenne sous test au récepteur de signaux radiofréquences lorsque l'antenne sous test fonctionne en réception, et une deuxième position dite d'étalonnage des canaux, dans laquelle le dispositif de commutateurs, de diviseurs et/ou de coupleurs relie au moins l'une des premières sorties de l'émulateur à l'entrée du récepteur sans passer par le réseau de sondes, la deuxième position étant distincte de la première position.
- en ce qu'il permet, lorsque l'objet sous test est sans fil, et pour l'ensemble de commutateurs, de diviseurs et/ou de coupleurs ayant la première position dite de mesure, de relier au moins l'une des premières sorties de l'émulateur de canaux à respectivement au moins l'une des sondes du réseau via au moins un canal associé et de relier une antenne de communication, située dans la chambre de mesure et assurant un lien rayonné avec l'objet sous test, au récepteur de signaux radiofréquences lors de la mesure de l'objet sous test recevant les signaux provenant des sondes du réseau. Le générateur et le récepteur de signaux radiofréquences correspondent ici en général à ce que l'homme de l'art appelle un testeur de radiocommunication. Le dispositif permet, pour l'ensemble de commutateurs, de diviseurs et/ou de coupleurs ayant la deuxième position dite d'étalonnage des canaux, de relier au moins l'une des premières sorties de l'émulateur à l'entrée du récepteur sans passer par le réseau de sondes.

Suivant des modes de réalisation de l'invention :
- Pour une antenne sous test alimentée par un câble et fonctionnant en réception, dans la première position dite de mesure, l'ensemble de commutation relie la multiplicité des premières sorties de l'émulateur à respectivement la pluralité des sondes via la multiplicité des canaux associés et relie l'antenne sous test à l'entrée du récepteur de signaux radiofréquences, et dans la deuxième position dite d'étalonnage des canaux, l'ensemble de commutation relie la multiplicité des premières sorties de l'émulateur à l'entrée de réception de l'unité d'analyse sans passer par le réseau de sondes, la deuxième position étant distincte de la première position.
- Pour une antenne sous test alimentée par un câble et fonctionnant en émission, dans la première position dite de mesure, l'ensemble de commutation relie la multiplicité des premières entrées de l'émulateur à respectivement la pluralité des sondes via la multiplicité des canaux associés et relie l'antenne sous test à la sortie du générateur de signaux radiofréquences, et dans la deuxième position dite d'étalonnage des canaux, l'ensemble de commutation relie la multiplicité des premières entrées de l'émulateur à la sortie du générateur de signaux radiofréquences sans passer par le réseau de sondes, la deuxième position étant distincte de la première position.
- Pour un objet sous test sans fil recevant les signaux provenant des sondes du réseau, dans la première position dite de mesure, l'ensemble de commutation relie la multiplicité des premières sorties de l'émulateur à respectivement la pluralité des sondes via la multiplicité des canaux associés et relie l'antenne de communication, située dans la chambre de mesure et assurant un lien rayonné avec l'objet sous test, à l'entrée du récepteur de signaux radiofréquences, et dans la deuxième position dite d'étalonnage des canaux, l'ensemble de commutation relie la multiplicité des premières sorties de l'émulateur à l'entrée de réception de l'unité d'analyse sans passer par le réseau de sondes, la deuxième position étant distincte de la première position.
- Pour un objet sous test sans fil émettant vers les sondes du réseau, dans la première position dite de mesure, l'ensemble de commutation relie la multiplicité des premières entrées de l'émulateur à respectivement la pluralité des sondes via la multiplicité des canaux associés et relie l'antenne de communication, située dans la chambre de mesure et assurant un lien rayonné avec l'objet sous test, à la sortie du générateur de signaux radiofréquences, et dans la deuxième position dite d'étalonnage des canaux, l'ensemble de commutation relie la multiplicité des premières entrées de l'émulateur à la sortie du générateur de signaux radiofréquences sans passer par le réseau de sondes, la deuxième position étant distincte de la première position.
- Le dispositif d'étalonnage comporte des moyens de commande de l'ensemble de commutation pour le faire passer entre l'une et l'autre des première et deuxième positions et pour le maintenir dans l'une quelconque des première et deuxième positions.
- L'ensemble de commutation comporte des commutateurs, des diviseurs et/ou des coupleurs et/ou analogues ayant lesdites positions pour assurer lesdites liaisons.

Suivant un mode de réalisation de l'invention, il est prévu un procédé d'étalonnage des canaux entre la sortie du générateur de signal RF jusqu'à l'entrée des sondes d'un réseau d'une pluralité de sondes d'émission de rayonnement, à l'aide d'un dispositif d'étalonnage tel qu'indiqué ci-dessus, caractérisé en ce que :
- on place l'ensemble de commutation dans la deuxième position dite d'étalonnage des canaux, dans laquelle l'ensemble de commutation relie au moins l'une des premières sorties de l'émulateur de canaux à l'entrée de réception de l'unité d'analyse sans passer par le réseau de sondes,
- puis on acquiert et on enregistre les valeurs du coefficient de transmission complexe pour chaque canal entre le générateur et le récepteur de signaux radiofréquences en passant par l'émulateur de canaux,
- puis on place l'ensemble de commutation dans la première position dite de mesure, dans laquelle l'ensemble de commutation relie au moins l'une des premières sorties de l'émulateur à respectivement au moins l'une des sondes via le au moins un canal associé et relie l'entrée de réception à l'antenne test.
- puis on applique lors de la mesure ou après la mesure de l'antenne sous test les corrections complexes obtenues pour chaque canal à partir des valeurs complexes enregistrées des coefficients de transmission lorsque l'ensemble de commutation était placé dans la deuxième position dite d'étalonnage des canaux. Cette correction permet d'uniformiser les caractéristiques des canaux notamment en termes de phase, d'amplitude et de temps de groupe en incluant les caractéristiques et les variabilités de l'émulateur de canaux et de tous les éléments actifs placés entre le générateur de signaux radiofréquences et les entrées des sondes du réseau.
- enfin, à cette correction des différents canaux, il est possible d'appliquer une seconde correction dont les valeurs sont obtenues à partir de l'étalonnage du réseau de sonde effectué par ailleurs et de façon totalement indépendante de l'étalonnage des canaux.

L'invention sera mieux comprise à la lumière de la description qui va suivre, donnée uniquement à titre d'exemple non limitatif en référence aux dessins annexés sur lesquels :

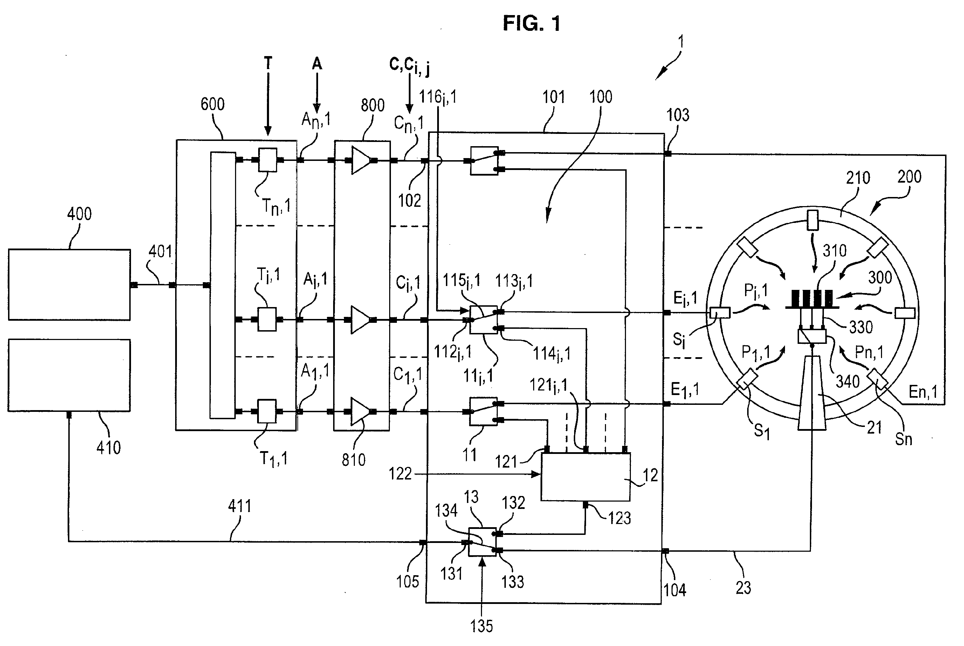

- la figure 1 est une vue schématique du dispositif d'étalonnage des canaux suivant un mode de réalisation de l'invention, et mis en oeuvre dans un système de génération d'environnements électromagnétiques avec une première position de l'ensemble de commutation pour réaliser la mesure d'un ensemble d'antennes sous test alimentées par un câble et fonctionnant en réception,

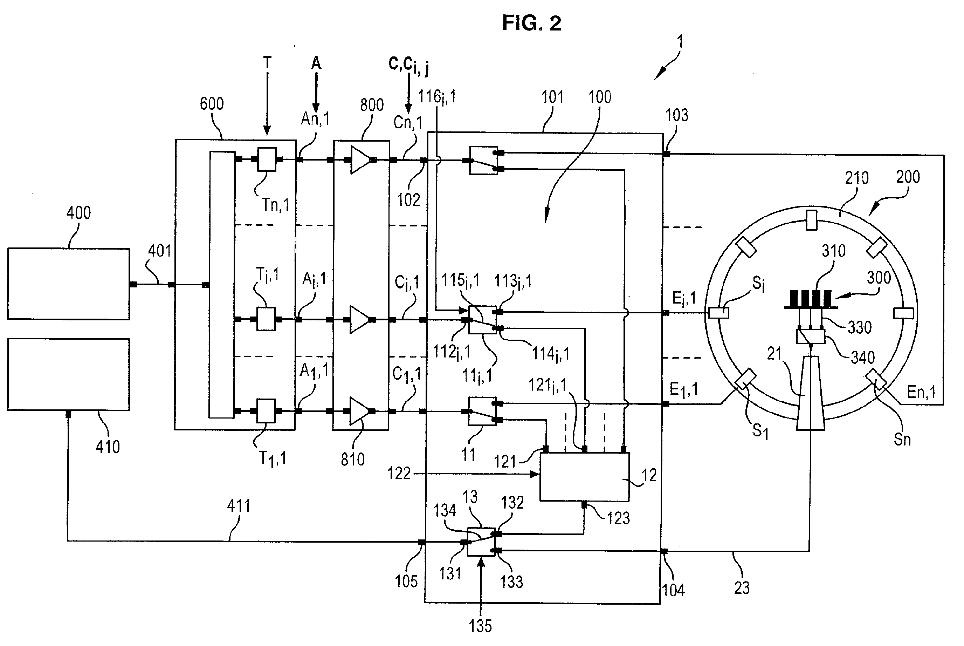

- la figure 2 est une vue schématique du dispositif d'étalonnage de la figure 1 suivant un mode de réalisation de l'invention avec une deuxième position de l'ensemble de commutation pour réaliser la mesure d'étalonnage des canaux,

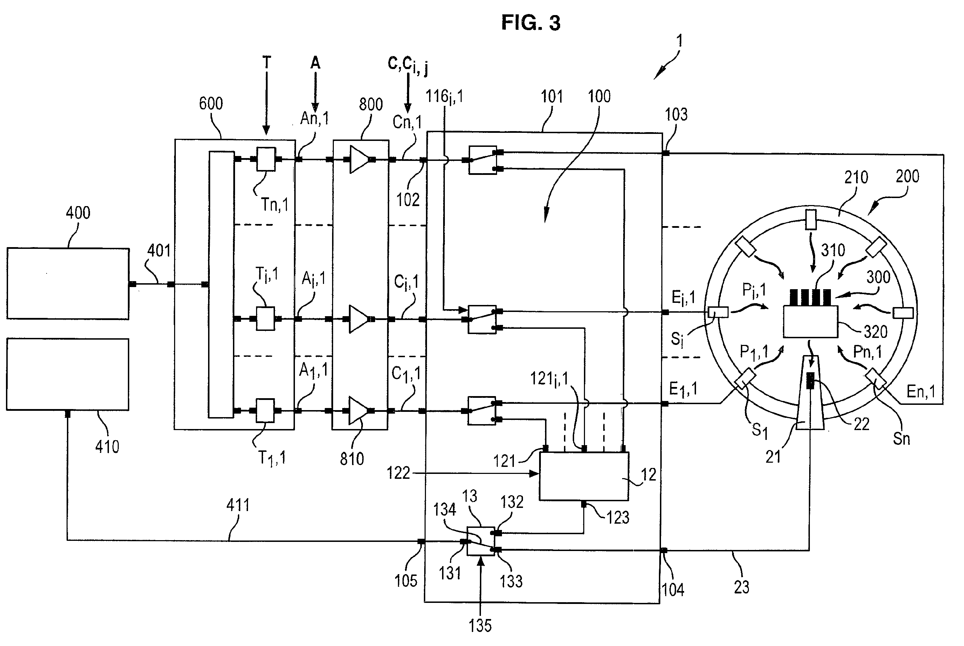

- la figure 3 est une vue schématique du dispositif d'étalonnage des canaux suivant un mode de réalisation de l'invention et mis en oeuvre dans un système de génération d'environnements électromagnétiques avec une première position de l'ensemble de commutation pour réaliser la mesure d'un objet sous test sans fil recevant les signaux provenant des sondes du réseau,

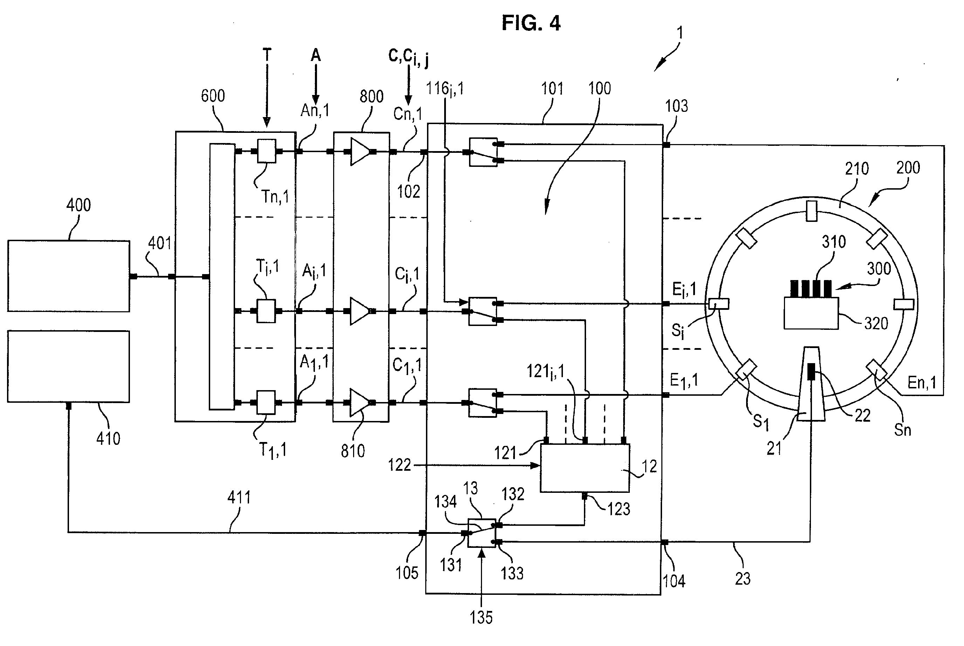

- la figure 4 est une vue schématique du dispositif d'étalonnage de la figure 3 suivant un mode de réalisation de l'invention avec une deuxième position de l'ensemble de commutation pour réaliser la mesure d'étalonnage des canaux,

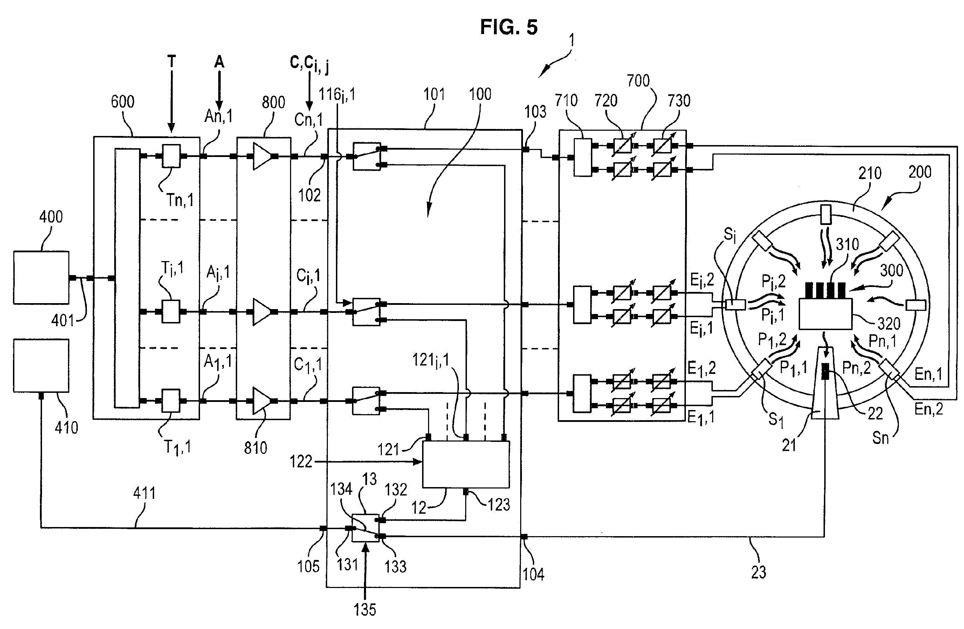

- la figure 5 est une vue schématique du dispositif d'étalonnage des canaux suivant un mode de réalisation de l'invention et mis en oeuvre dans un système de génération d'environnements électromagnétiques avec une première position de l'ensemble de commutation pour réaliser la mesure d'un objet sous test sans fil recevant les signaux provenant des sondes bipolarisées du réseau, elles-mêmes alimentées à travers des ensembles additionnels de génération de polarisation,

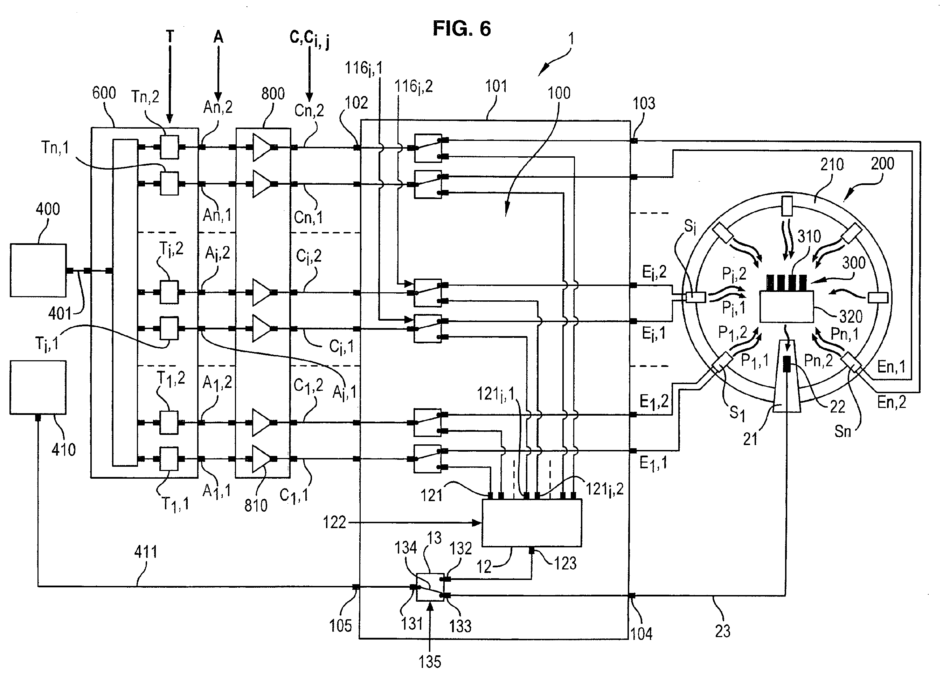

- la figure 6 est une vue schématique du dispositif d'étalonnage des canaux suivant un mode de réalisation de l'invention et mis en oeuvre dans un système de génération d'environnements électromagnétiques avec une première position de l'ensemble de commutation pour réaliser la mesure d'un objet sous test sans fil recevant les signaux provenant des sondes bipolarisées du réseau,

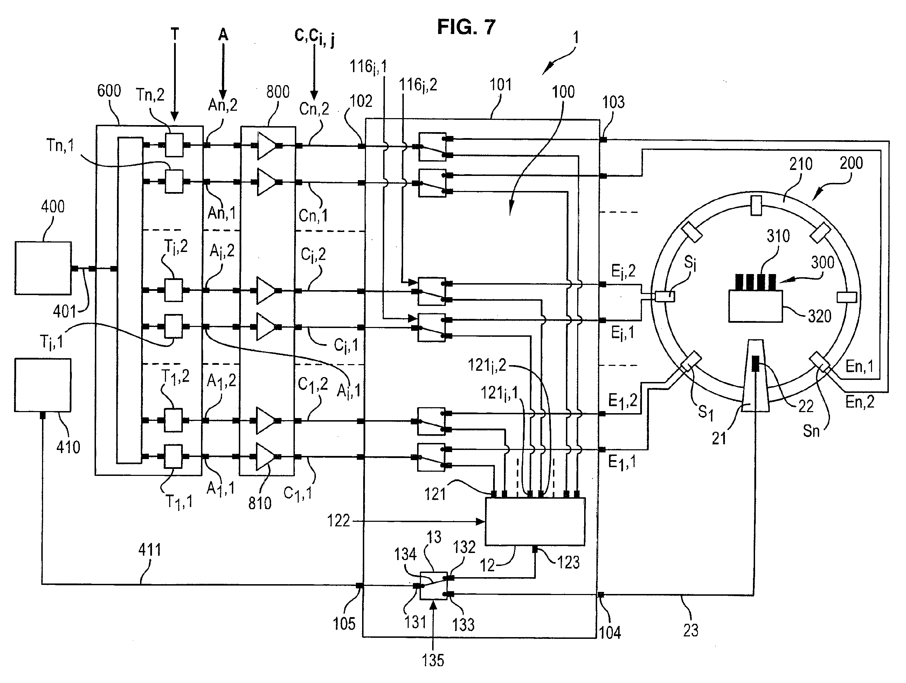

- la figure 7 est une vue schématique du dispositif d'étalonnage de la figure 6 suivant un mode de réalisation de l'invention avec une deuxième position de l'ensemble de commutation pour réaliser la mesure d'étalonnage des canaux,

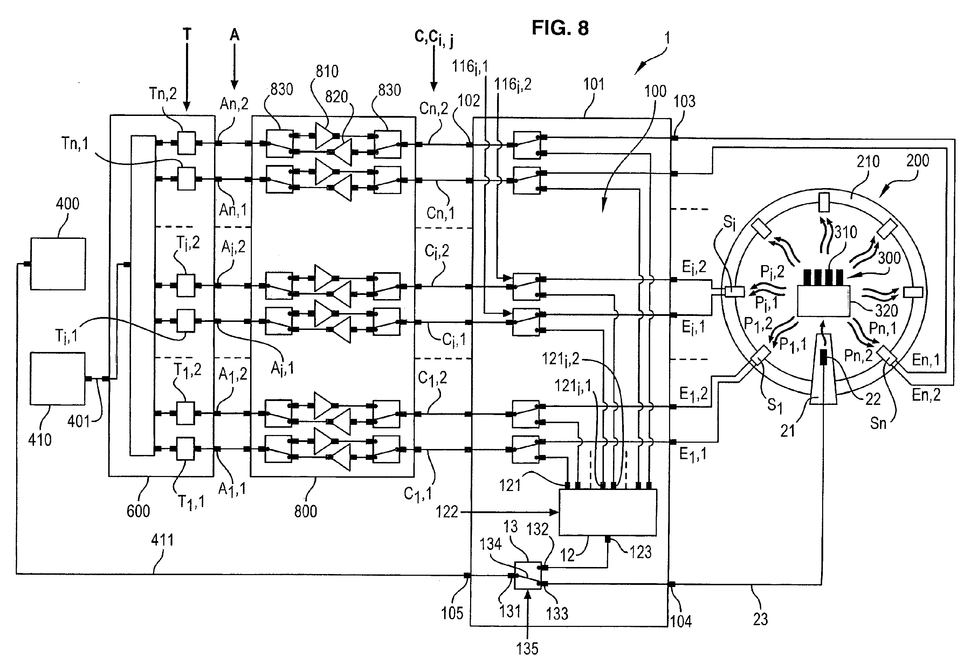

- la figure 8 est une vue schématique du dispositif d'étalonnage des canaux suivant un mode de réalisation de l'invention et mis en oeuvre dans un système de génération d'environnements électromagnétiques avec une première position de l'ensemble de commutation pour réaliser la mesure d'un objet sous test sans fil émettant vers les sondes bipolarisées du réseau.

Suivant un mode de réalisation de l'invention, le dispositif d'étalonnage des canaux 100 est mis en oeuvre au sein d'un système de génération d'environnements électromagnétiques 1 constitué au moins d'un réseau de sondes 200 de réception ou d'émission de rayonnements électromagnétiques vers une zone de test pour tester un objet sous test 300 situé dans cette zone de test, d'un générateur de signal 400 pour créer un ou plusieurs signaux radiofréquences, d'un récepteur de signal 410 pour recevoir et analyser un ou plusieurs signaux radiofréquences et d'un émulateur 600 de canaux utilisé pour pouvoir multiplexer et transformer le ou les signaux radiofréquences issus du générateur de signaux 400 à travers un ou plusieurs canaux C jusqu'aux entrées E des sondes S du réseau 200. Le nombre de sondes S du réseau de sondes 200 est supérieur ou égal à deux.

Chaque sonde S est apte à émettre un rayonnement électromagnétique suivant un diagramme de rayonnement prédéterminé qui lui est propre. Les sondes S du réseau sont orientées par exemple pour que le maximum de ces diagrammes de rayonnement pointe vers le centre de la zone de test. Les diagrammes de rayonnement sont fixes par rapport à leurs sondes associées. Bien entendu, les sondes S pourraient également être orientées autrement pour rayonner dans des directions quelconques autres que vers le centre de la zone de test.

Au centre de la zone de test est placé un objet sous test 300 composé d'une ou plusieurs antennes 310 pouvant être reliées à un émetteur ou un récepteur embarqué 320 comme sur les figures 3 à 8 (on parle alors d'objet sous test sans fil comme dans le cas d'un téléphone mobile ou d'un ordinateur portable) ou bien directement alimentées par des câbles 330 et sélectionnées par un commutateur 340 comme sur les figures 1 et 2 (on parle alors d'antennes sous test alimentées par câble)..

Dans le cas d'un objet sous test 300 sans fil, il est connu d'utiliser une antenne auxiliaire 22 comme représentée sur les figure 3 à 8 et permettant d'établir un lien de communication avec l'objet sous test de façon à recevoir des information de la part de l'objet sous test lorsque ce dernier reçoit des signaux provenant des sondes (figures 3, 5 et 6) ou bien d'envoyer des informations vers l'objet sous test lorsque ce dernier émet des signaux vers les sondes (figure 8).

Chaque sonde S comporte une ou deux entrées E suivant que la sonde est mono-polarisée (possédant un diagramme de rayonnement suivant une seule polarisation P) ou bi-polarisée (possédant un diagramme de rayonnement suivant deux polarisations P orthogonales) Les sondes S sont fixées suivant une géométrie prescrite sur un support 210 commun. Les sondes S peuvent également être mobiles autour de l'objet sous test 300.

Le réseau 200 de sondes S est par exemple à géométrie circulaire ou sphérique dont le centre coïncide avec le centre de la zone de test.

Dans un mode de réalisation, le réseau 200 de sondes S possède une disposition sphérique sur le support 210, dont le centre coïncide avec le centre de la zone de test..

Dans un autre mode de réalisation, le réseau 200 de sondes S est situé sur un support cylindrique 210, de section transversale par exemple circulaire dont l'axe passe par le centre de la zone de test.

Dans un autre mode de réalisation, tel que celui représenté à titre d'exemple aux figures, le réseau 200 de sondes S est porté par un support 210 en forme de couronne annulaire circulaire dans le plan vertical dont le centre coïncide avec le centre de la zone de test.

Dans un autre mode de réalisation, le support 210 du réseau 200 de sondes S pourrait être une arche en forme d'arc de cercle, par exemple semi-circulaire, dans le plan vertical ou bien horizontal et dont le centre coïncide avec le centre de la zone de test

Les sondes S sont par exemple réparties régulièrement sur leur support 210, par exemple de manière équiangle par rapport au centre de la zone de test, ainsi que cela est représenté aux figures.

Les sondes S se trouvent dans une chambre anéchoïde dont les parois intérieures sont entièrement recouvertes d'absorbants électromagnétiques pour empêcher les réflexions des rayonnements électromagnétiques, par exemple, ainsi que cela est connu, en forme de pyramides de mousse dont les sommets sont tournés vers l'intérieur de la chambre.

Le support 210 des sondes entoure le centre de la zone de test. Le support 210 peut être ouvert vers le bas pour permettre le passage d'un mât 21 de support de l'objet sous test 300.

Le support 210 des sondes a par exemple la forme d'un anneau.

Le support 210 des sondes est par exemple vertical aux figures.

Le support 210 des sondes peut également être horizontal ou avoir une inclinaison non nulle par rapport à l'horizontale et à la verticale.

Le support 210 des sondes peut également être distribué et réparti dans la chambre anéchoide en différents supports indépendants les uns des autres et soutenant une sonde S ou un groupe de sondes S du réseau 200.

Le mât 21 peut recevoir à son sommet un positionneur mécanique 2-axes permettant de basculer l'objet sous test de ±90 degrés autour du centre de la zone de test de façon à pouvoir effectuer des tests aussi bien dans le plan vertical (plan des élévations) ou horizontal (plan des azimuts) de l'objet sous test pour le cas d'une configuration de support 210 en forme de couronne annulaire circulaire placée dans le plan vertical comme représentée sur les figures 1 à 8.

L'entrée E de chaque sonde S est reliée à un canal C de transport d'un signal radiofréquence comme représenté aux figures 1 à 4. La sonde S émet donc un rayonnement électromagnétique vers la zone de test, qui correspond au signal radiofréquence présent sur son entrée E.

Réciproquement, la sonde peut recevoir un signal électromagnétique rayonné de la part de l'objet sous test situé dans la zone de test et transmettre le signal radiofréquence résultant sur le canal C relié à son entrée E.

Dans le cas de sondes S bi-polarisées, chacune des deux entrées E de la sonde correspondant à chacune des deux polarisations orthogonales P est en général reliée à un canal C de transport d'un signal radiofréquence comme représenté aux figures 6 à 8.

Dans le cas de sondes bi-polarisées, il est possible de rajouter comme sur la figure 5 un module 700 communément appelé unité de génération de polarisation qui permet de diviser le signal radiofréquence transporté par un canal et de pondérer chacune des deux voies ainsi créées en amplitude et en phase pour accéder aux deux entrées E de la sonde bipolarisée dont les deux polarisations orthogonales vont se combiner pour donner de la polarisation linéaire ou circulaire avec une discrimination de polarisation donnée suivant les coefficients de pondération utilisés. Dans un mode de réalisation, l'unité de génération de polarisation 700 est constituée, par exemple, d'ensembles comprenant chacun un diviseur deux voies 710, deux atténuateurs variables contrôlables 720 et deux déphaseurs variables contrôlable 730. Chacun des ensembles est relié à son entrée à un canal C et à ses deux sorties aux deux entrées E d'une sonde S bi-polarisée. L'unité de génération de polarisation 700 constitue un moyen économique permettant de diviser par deux le nombre de canaux C dans le cas de sondes S bi-polarisées. Néanmoins, dans ce cas, les deux polarisations de la sonde S sont liées et émises simultanément, ce qui n'est pas le cas lorsque chacune des entrées E de la sonde est connectée à un canal indépendant C.

Un émulateur de canaux 600 (en anglais appelé « channel emulator ») est utilisé pour multiplexer et transformer le ou les signaux radiofréquences issus du générateur de signaux 400 à travers un ou plusieurs canaux C jusqu'aux entrées E des sondes S du réseau 200. De façon réciproque, l'émulateur de canaux 600 peut être utilisé pour multiplexer et transformer le ou les signaux radiofréquences issus des entrées E des sondes S du réseau 200 à travers un ou plusieurs canaux C jusqu'au récepteur de signaux 410. L'émulateur de canaux 600 comporte des accès en général bi-directionnels A correspondant à chaque canal C relié à chaque entrée E de chaque sonde S comme présenté dans les figures 1 et 3 ou bien relié à chaque entrée de chaque diviseur 2 voies 710 de l'unité de génération de polarisation 700 comme présenté dans la figure 5. Dans le cas de sondes bi-polarisées, il est aussi possible d'associer deux canaux C reliés chacun à une des deux entrées E de la sonde S comme présenté dans les figures 6 et 8.. Par conséquent, pour la pluralité de sondes S₁, ....., Sᵢ,....., Sₙ, il est prévu une pluralité d'accès A₁,₁,...., A_{i,1},...., A_{n,1} correspondant à une pluralité de canaux C_{1,1},...., C_{i,1}, ....., C_{n,1} avec 1 ≤ i ≤ n et n ≥ 2 dans le cas d'un canal unique par sonde comme dans les figures 1 à 5. Pour la pluralité de sondes S₁, ....., Sᵢ,....., Sₙ, il est prévu une pluralité d'accès A_{1,1}, A_{1,2}...., A_{i,1}, A_{i,2}...., A_{n,1}, A_{n,2} et une pluralité de canaux C_{1,1}, C_{1,2}...., C_{i,1}, C_{i,2}....., C_{n,1}, C_{n,2} avec 1 ≤ i ≤ n et n ≥ 2 dans le cas de deux canaux distincts par sonde comme dans les figures 6 à 8.. Il est connu que l'émulateur de canaux 600 possède des moyens de transformation en général numériques et contrôlables T des signaux radiofréquences issus du générateur de signal 400 pour chaque canal C. Ces moyens de transformation T permettent chacun d'appliquer ou pas de façon indépendante des modifications par exemple de la phase, de l'amplitude et du temps de groupe au signal radiofréquence transporté par chaque canal C. Il est donc possible à l'aide de ces moyens de transformation T d'appliquer de façon indépendante des corrections complexes sur le signal radiofréquence de chacun des canaux C.

De façon à obtenir un bilan de puissance convenable du système de génération d'environnements électromagnétiques, il est connu que chacun des accès A_{i,j} de l'émulateur de canaux 600 peut être connecté à un amplificateur 810 du signal radiofréquence. Ces amplificateurs 810 font parti d'un module 800 appelé unité d'amplification comme présenté sur les figures 1 à 7. Il est aussi envisageable d'utiliser des amplificateurs faibles bruits 820 pour amplifier les signaux radiofréquences provenant des sondes S dans le cas d'une configuration de mesure du réseau de sondes en réception comme montré sur la figure 8. Dans ce dernier cas, on peut aussi mettre en oeuvre une unité d'amplification 800 bidirectionnelle comprenant des ensembles composés chacun de deux commutateurs 830, d'un amplificateur 810 et d'un amplificateur 820 monté tête-bêche pour permettre, suivant les positions des commutateurs 830, d'amplifier le signal radiofréquence transporté par chaque canal C depuis le générateur de signal 400 vers l'entré E des sondes S ou bien d'amplifier le signal radiofréquence provenant de chaque entrée E des sondes S et transporté par chaque canal C vers le récepteur 410 comme présenté sur la figure 8.

Suivant un mode de réalisation de l'invention, le dispositif d'étalonnage des canaux 100 est placé entre l'émulateur de canaux 600 et le réseau de sondes 200 et plus précisément entre l'unité d'amplification 800 et l'unité de génération de polarisation 700 si elles existent.

Suivant un mode de réalisation de l'invention, le dispositif d'étalonnage des canaux 100 comprend :
- Un ensemble de commutateurs ou de coupleurs ou de diviseurs 11 interposés entre les accès A de l'émulateur de canaux 600 et les entrées E des sondes S du réseau 200. Plus précisément et pour exemple, un commutateur 11_{i,1} comprend un accès commun 112_{i,1} connecté pour chaque canal C_{i,1} à l'accès A_{i,1} de l'émulateur 600 à travers l'unité d'amplification 800 si existante comme dans les figures 1 à 8, un accès 113_{i,1} connecté à l'entrée E_{i,1} de la sonde Sᵢ du réseau 200 comme sur les figures 1 à 4 et 6 à 8 ou bien aux deux entrées E_{i,1} et E_{i,2} de la sonde Sᵢ à travers l'unité de génération de polarisation 700 si existante comme sur la figure 5 et un accès 114_{i,1} connecté à l'accès 121_{i,1} de l'ensemble de commutateurs ou de diviseurs 12. La position de l'organe de commutation 115_{i,1} du commutateur 11_{i,1} est commandée au moyen d'un signal de commande 116_{i,1} et permet dans une position de relier l'accès commun 112_{i,1} à l'accès 113_{i,1} comme dans les figures 1, 3, 5, 6 et 8 et dans l'autre position de relier l'accès commun 112_{i,1} à l'accès 114_{i,1} comme dans les figures 2, 4 et 7.
- Un ensemble de commutateurs ou de diviseurs 12 dont les accès 121 sont connectés aux accès 114 des commutateurs ou coupleurs ou diviseurs 11 et dont l'accès commun 123 est connecté à l'accès 132 du commutateur 13. Plus précisément et pour exemple, l'accès 121_{i,1} de l'ensemble de commutateurs 12 est connecté à l'accès 114_{i,1} du commutateur 11_{i,1} comme représenté sur les figures 1 à 8. Les positions des organes de commutation de l'ensemble de commutateurs 12 sont commandées au moyen de signaux de commande 122 et permettent de relier un accès quelconque 12_{i,j} à l'accès commun 123.
- Un commutateur 13 dont l'accès 132 est connecté à l'accès commun 123 de l'ensemble de commutateurs ou de diviseurs 12, dont l'accès 133 est connecté au câble 23 reliant soit l'antenne sous test 310 (figures 1 et 2) ou bien l'antenne de communication 22 (figures 3 à 8) et dont l'accès commun 131 est connecté au câble 411 reliant le récepteur 410 de signal radiofréquence dans le cas d'une configuration de mesure avec les sondes S du réseau 200 fonctionnant en émission (figures 1 à 7) ou bien reliant le générateur 400 de signal radiofréquence dans le cas d'une configuration de mesure avec les sondes S du réseau 200 fonctionnant en réception.(figure 8). La position de l'organe de commutation 134 du commutateur 13 est commandée au moyen d'un signal de commande 135 et permet dans une position de relier l'accès commun 131 à l'accès 133 comme dans les figures 1, 3, 5, 6 et 8 et dans l'autre position de relier l'accès commun 131 à l'accès 132 comme dans les figures 2, 4 et 7.

Les éléments 11, 12 et 13 sont par exemple regroupés dans une unité 100 d'étalonnage des canaux à l'intérieur d'un même boîtier physique 101. Les différentes interfaces physiques de ce boîtier 101 sont matérialisées par des connecteurs 102 reliés aux accès communs 112 des commutateurs ou diviseurs ou coupleurs 11, des connecteurs 103 reliés aux accès 113 des commutateurs ou diviseurs ou coupleurs 11, un connecteur 104 relié à l'accès 133 du commutateur 13 et un connecteur 105 relié à l'accès commun 131 du commutateur 13. Ainsi tous les coefficients de transmission complexe de tous les chemins possibles entre les différents connecteurs du boîtier 101 en fonction des différentes positions des organes de commutation des éléments 11, 12 et 13 peuvent être caractérisés et enregistrés de manière totalement indépendante et séparée du moyen de génération d'environnement électromagnétique pour ensuite être utilisés dans le calcul des coefficients de correction de chaque canal. Dans un mode de réalisation, on calibrera jusqu'à la transition de paroi en sortie du boitier 101.

Suivant un mode de réalisation de l'invention, le fonctionnement du dispositif d'étalonnage des canaux 100 est le suivant :
Dans la première position du dispositif d'étalonnage des canaux 100 représentée aux figures 1, 3, 5, 6 et 8, le dispositif est utilisé de façon transparente pour mesurer l'objet sous test 300 avec le système de génération d'environnements électromagnétiques.
Dans cette première position, pour chaque canal C_{i,j}, le commutateur 11ᵢⱼ relie la sortie Aᵢⱼ de l'émulateur de canaux 600 à l'entrée E_{i,j} de la sonde Sᵢ du réseau 200 à au moyen de l'accès commun 112_{i,j} relié à l'accès 113_{i,j} par l'organe de commutation 115_{i,j}. Dans cette première position, le commutateur 13 relie le câble 23 provenant de l'antenne sous test 310 ou de l'antenne de communication 22 au récepteur de signaux radioélectriques 410 pour les configurations de mesure des figures 1, 3, 5 et 6 ou au générateur de signaux radioélectriques 400 pour la configuration de mesure de la figure 8 au moyen de l'accès 133 relié à l'accès commun 131 par l'organe de commutation 134.
Dans cette première position, les signaux radiofréquences transmis aux entrées E_{i,j} des différentes sondes Sᵢ à travers les canaux C_{i,j} permettent de simuler un environnement électromagnétique donné,, chaque signal radiofréquence de chaque canal C_{i,j} étant alors propre à chaque entrée E_{i,j} de chaque sonde Sᵢ et pouvant être différent et prédéterminé d'une entrée de sonde à l'autre.
Dans cette première position, les signaux provenant de l'antenne sous test 310 (figure 1) ou de l'antenne de communication 22 (figures 3, 5 et 6) sont commutés par le commutateur 13 vers le récepteur de signaux radiofréquences 410. Dans cette première position, pour une configuration de mesure avec les sondes S du réseau 200 fonctionnant en réception (figure 8), les signaux provenant du générateur de signaux radiofréquences 400 peuvent être commutés par le commutateur 13 vers l'antenne de communication 22 ou bien l'antenne sous test 310.
Bien entendu, dans la première position, un seul canal Q_{i,j} ou un sous-ensemble des canaux C pourraient être commutés par les commutateurs 11 sur les entrées E des sondes S, tandis que les autres canaux ne sont pas commutés sur leur entrée de sonde associée. Par conséquent, dans la première position, au moins un canal C_{i,j} est commuté par le commutateur 11_{i,j} sur l'entrée E_{i,j} de la sonde Sᵢ. Dans cette première position, au moins un canal C_{i,j}, un sous ensemble des canaux C ou tous les canaux C sont commutés par le commutateur 11_{i,j}, un sous-ensemble des commutateurs 11 ou tous les commutateur 11 sur l'entrée E_{i,j} de la sonde Si, un sous ensemble des entrées E des sondes S ou toutes les entrées E des sondes S.

Dans la deuxième position du dispositif d'étalonnage des canaux 100 représentée aux figures 2, 4 et 7, le dispositif 100 est utilisé pour effectuer les mesures d'étalonnage des canaux sans passer par les sondes S du réseau de sonde 200 et sans passer par l'antenne sous test 310 ou l'antenne de communication 22. C'est donc une étape mise en oeuvre préalablement à la première position du dispositif 100 pour la mesure de l'objet sous test.

Dans cette deuxième position, pour chaque canal C_{i,j}, le commutateur 11ᵢⱼ relie la sortie Aᵢⱼ de l'émulateur de canaux 600 à l'accès 121_{i,j} de l'ensemble de commutateurs ou de diviseurs 12 au moyen de l'accès commun 112_{i,j} relié à l'accès 114_{i,j} par l'organe de commutation 115_{i,j.} Dans cette deuxième position, l'ensemble de commutateurs ou de diviseurs 12 permet d'acheminer l'un sélectionné des accès 121_{i,j} relié à l'accès 114_{i,j} vers l'accès commun 123. Dans cette deuxième position, le commutateur 13 relie l'accès 132 lui-même relié à l'accès commun 123 au récepteur de signaux radioélectriques 410 pour les configurations d'étalonnage des figures 2, 4 et 7 au moyen de l'accès 132 relié à l'accès commun 131 par l'organe de commutation 134 ou de manière réciproque au générateur de signaux radioélectriques 400 dans le cas d'une mise en oeuvre du système de génération d'environnements électromagnétiques avec les sondes du réseau 200 configurées pour recevoir les rayonnements émis par l'objet sous test.

Dans cette deuxième position, au moins un canal C_{i,j}, un sous-ensemble des canaux C ou tous les canaux C sont commutés par le commutateur 11_{i,j}, un sous-ensemble des commutateurs 11 ou tous les commutateurs 11 sur l'accès 121_{i,j}, un sous-ensemble des accès 121 ou tous les accès 121 de l'ensemble de commutateurs ou de diviseurs 12.

Lorsqu'un accès 121_{i,j} est sélectionné sur le module 12, le signal radiofréquence du canal C_{i,j} est alors acheminé à l'accès commun 123, puis au récepteur de signaux 410 via l'accès 132 relié à l'accès commun 131 par l'organe 134 de commutation et la voie 411 de retour. Cette deuxième position permet donc de mesurer et d'enregistrer l'ensemble des caractéristiques complexes de chaque canal depuis le générateur de signal 400 jusqu'au récepteur de signal 410 sans passer par le réseau de sonde. Les valeurs complexes ainsi mesurée pourront ensuite être utilisés dans le calcul des coefficients de correction de chaque canal.

En variante, l'ensemble des signaux présents sur tous les accès 121 sont transmis sous une forme multiplexée par le module 12 sur l'accès commun 123.

Une unité de commande est prévue pour commander depuis l'extérieur les entrées de commande 116, 135 de commutation des commutateurs 11 et 13, ainsi que de l'entrée de commande 122 lorsque cette entrée 122 est présente. Dans le cas où le multiplexeur 12 est totalement passif, il n'y a pas de commande 122. Il est donc prévu des moyens 116, 135 de commande du dispositif 100 d'étalonnage des canaux pour le faire passer entre l'une et l'autre des première et deuxième positions.

Suivant un mode de réalisation de l'invention, un procédé d'étalonnage des canaux entre le plan correspondant à la sortie du générateur de signal radiofréquence 400 et le plan correspondant aux accès 103 du boîtier 101 contenant le dispositif d'étalonnage des canaux 100 est constitué des étapes principales suivantes :
- On mesure et on enregistre tous les coefficients de transmission complexe de tous les chemins possibles entre les plans d'accès 102 et 103 et de tous chemins possibles entre les plans d'accès 102 et 105 du boîtier 101 en fonction des différentes positions des organes de commutation des éléments 11, 12 et 13. Ces coefficients de transmission complexes peuvent être caractérisés et enregistrés de manière totalement indépendante et séparée (en usine par exemple) du moyen de génération d'environnements électromagnétiques. Ces coefficients de transmission complexes sont mesurés sur la plage de fréquence de fonctionnement du système 1. La mesure de ces coefficients de transmission complexes peut être répétée à des intervalles de temps très espacés de l'ordre d'une ou plusieurs années et compatibles avec les étalonnages des appareils de mesure hyperfréquences conventionnels.

On place le dispositif 100 dans la deuxième position dite d'étalonnage des canaux, dans laquelle au moins un des canaux C_{i,j} est relié à l'entrée du récepteur de signaux radiofréquences 410 sans passer par le réseau de sondes 200 ou bien réciproquement à la sortie du générateur de signaux radiofréquences 400 sans passer par le réseau de sondes 200.
- On mesure et on enregistre les valeurs du coefficient de transmission complexe pour chaque canal C_{i,j} entre le plan correspondant à la sortie du générateur de signaux radiofréquences 400 et le plan correspondant à l'entrée du récepteur de signaux radiofréquences 410 en passant par l'émulateur de canaux 600 et l'unité d'amplification 800 si existante. Ces coefficients de transmission complexes sont mesurés sur la plage de fréquence de fonctionnement du système 1. La mesure de ces coefficients de transmission complexes doit être répétée à des intervalles de temps rapprochés pour pouvoir prendre en compte l'évolution dans le temps des caractéristiques de l'émulateur de canaux 600 et des différents éléments actifs comme l'unité d'amplification 800 placés entre le générateur de signaux radiofréquences 400 et le système d'étalonnage des canaux 100. Ces intervalles de temps peuvent être de l'ordre de l'heure ou de plusieurs heures. Il est parfois nécessaire de réaliser cette mesure à chaque mise sous tension de l'émulateur de canaux et des éléments actifs placés entre le générateur de signaux radiofréquences 400 et le système d'étalonnage des canaux 100.
- On calcule à partir des coefficients complexes mesurés aux étapes précédentes et on enregistre les valeurs complexes des corrections à apporter à chaque canal de transmission C_{i,j} pour rendre uniforme les réponses des canaux C en termes notamment de phase, d'amplitude et de temps de groupe sur la bande de fréquences qui sera utilisée pour les mesures par la suite. Ces corrections incluent les caractéristiques et les variabilités (par exemple les variabilités temporelles, les variabilités thermiques, etc.) de l'émulateur de canaux 600 et de tous les éléments actifs placés entre le générateur de signaux radiofréquences 400 et le système d'étalonnage des canaux 100.
- On place le dispositif 100 dans la première position dite de mesure, dans laquelle au moins un des canaux C_{i,j} est relié à l'entrée E_{i,j} de la sonde Sᵢ et l'antenne sous test 310 ou l'antenne de communication 22 est reliée à l'entrée du récepteur de signaux radiofréquences 410.
- On applique lors de la mesure ou après la mesure de l'objet sous test 300 les valeurs complexes de corrections calculées aux étapes précédentes pour chaque canal C_{i,j}.

Suivant un mode de réalisation de l'invention, le procédé d'étalonnage des canaux au moyen du dispositif d'étalonnage 100 dissocie les actions d'étalonnage des canaux C des actions d'étalonnage du réseau de sondes 200 permettant :
- De rendre complètement indépendants l'étalonnage des canaux C et l'étalonnage du réseau de sondes 200. L'étalonnage du réseau de sondes 200, consistant notamment à uniformiser les réponses des sondes en termes de phase, d'amplitude, d'axe radioélectrique, de centre de phase et de temps de groupe peut donc être réalisé séparément avec des techniques éprouvées et très précises à des intervalles de temps de l'ordre de l'année et compatibles avec les étalonnages des appareils de mesure hyperfréquences conventionnels.
- D'appliquer une correction à chaque canal C_{i,j} dont les valeurs complexes sont obtenues à partir de l'étalonnage des canaux C effectué de façon indépendante de l'étalonnage du réseau de sonde.
- D'appliquer une correction supplémentaire à chaque canal C_{i,j} dont les valeurs complexes sont obtenues à partir de l'étalonnage du réseau de sonde effectué séparément et de façon totalement indépendante de l'étalonnage des canaux.

Par conséquent, le dispositif suivant l'invention permet de corriger la variabilité de l'émulateur de canaux 600 et des éléments actifs comme l'unité d'amplification 800, en permettant de ré-étalonner chaque canal C_{i,j} fréquemment, de façon très rapide, automatisable et indépendamment du réseau de sondes 200, ce qui évite de devoir à chaque fois étalonner une nouvelle fois les sondes, l'étalonnage des canaux devenant ainsi aisé, rapide et très précis. Les corrections effectuées à partir d'étalonnages des canaux réalisés plus fréquemment permettent ainsi des mesures plus stables et plus précises dans le temps d'objets sous test 300 au moyen du système de génération d'environnements électromagnétiques 1. Cette précision est renforcée par le fait que l'étalonnage des canaux devenu ainsi indépendant de l'étalonnage des sondes permet de réaliser un étalonnage des sondes avec des méthodes éprouvées et très précises et d'appliquer des corrections supplémentaires et très efficaces à chaque canal C_{i,j} pour uniformiser la réponse des sondes pour chaque canal C_{i,j}.

On obtient donc un dispositif et un procédé d'étalonnage rapide, aisé, précis et large bande des canaux d'un système de génération d'environnements électromagnétiques comportant un réseau d'une pluralité de sondes.

Dans ce qui précède, le générateur forme la première unité (400) d'émission de signal, le récepteur forme la deuxième unité (410) de réception de signal.

## Revendications

1. Système de simulation d'environnements électromagnétiques, comportant :
- un réseau (200) d'une pluralité de sondes (Si) d'émission et/ou de réception de rayonnements électromagnétiques vers ou depuis un point test distant des sondes (Sᵢ) pour tester au moins une antenne test (300) située au point test,
- une multiplicité de canaux (C) de liaison des sondes à un émulateur (600) de canaux,
- une première unité (400) d'émission de signal,
- une deuxième unité (410) de réception de signal,
- l'une des première et deuxième unités (400, 410) étant reliée à l'émulateur (600) de canaux,
**caractérisé par** un dispositif de commutation (100) ayant une première position de mesure, dans laquelle le dispositif de commutation (100) relie l'émulateur (600) à respectivement au moins l'une (Sᵢ) des sondes via le au moins un canal associé (C) et relie l'autre des première et deuxième unités (410, 400) à l'antenne test (300), et une deuxième position d'étalonnage des canaux (C), dans laquelle le dispositif de commutation (100) relie l'émulateur (600) à l'autre des première et deuxième unités (410, 400) via le au moins un canal associé (C) sans passer par le réseau (200) de sondes (Sᵢ), la deuxième position étant distincte de la première position.

2. Système suivant la revendication 1, **caractérisé en ce que** l'émulateur (600) de canaux est relié à la première unité (400) d'émission de signal, le dispositif (100) de commutation dans la première position de mesure relie l'émulateur (600) à respectivement au moins l'une (Si) des sondes via le au moins un canal associé (C) et relie la deuxième unité (410) de réception de signal à l'antenne test (300), et le dispositif (100) de commutation dans la deuxième position d'étalonnage des canaux (C) relie l'émulateur (600) à la deuxième unité (410) de réception de signal via le au moins un canal associé (C) sans passer par le réseau (200) de sondes (Sᵢ).

3. Système suivant la revendication 1, **caractérisé en ce que** l'émulateur (600) de canaux est relié à la deuxième unité (410) de réception, le dispositif (100) de commutation dans la première position de mesure relie l'émulateur (600) à respectivement au moins l'une (Sᵢ) des sondes via le au moins un canal associé (C) et relie la première unité (400) d'émission de signal de signal à l'antenne test (300), et le dispositif (100) de commutation dans la deuxième position d'étalonnage des canaux (C) relie l'émulateur (600) à la première unité (400) d'émission via le au moins un canal associé (C) sans passer par le réseau (200) de sondes (Sᵢ).

4. Système suivant l'une quelconque des revendications précédentes, **caractérisé en ce que** le dispositif de commutation (100) dans la première position de mesure relie une multiplicité d'accès (A) de l'émulateur (600) à respectivement la pluralité des sondes (Sᵢ) via la multiplicité des canaux associés (C) et relie l'autre des première et deuxième unités (410, 400) à l'antenne test (300), et le dispositif de commutation (100) dans la deuxième position d'étalonnage des canaux (C) relie la multiplicité d'accès (A) de l'émulateur (600) à l'autre des première et deuxième unités (410, 400) via la multiplicité des canaux associés (C) sans passer par le réseau (200) de sondes (Sᵢ), la deuxième position étant distincte de la première position.

5. Système suivant l'une quelconque des revendications précédentes, **caractérisé en ce que** l'émulateur de canaux 600 possède des moyens (T) de transformation contrôlables pour faire varier individuellement pour chaque canal (C) au moins l'une parmi la fréquence, la phase, l'amplitude et les polarisations du signal de chaque sonde (Sᵢ) associée.

6. Système suivant l'une quelconque des revendications précédentes, **caractérisé en ce qu'**il comporte des moyens (116, 122, 135) de commande du dispositif de commutation (100) pour le faire passer entre l'une et l'autre des première et deuxième positions et pour le maintenir dans l'une quelconque des première et deuxième positions.

7. Système suivant l'une quelconque des revendications précédentes, **caractérisé en ce que** le dispositif de commutation (100) comporte des commutateurs ou analogues (11, 13) ayant lesdites positions pour assurer lesdites liaisons.

8. Système suivant l'une quelconque des revendications précédentes, **caractérisé en ce qu'**il comprend une unité (700) de génération de deux première et deuxième polarisations orthogonales entre elles pour diviser le signal transporté par ledit au moins un canal (C) en deux première et deuxième voies (710) ayant respectivement les deux première et deuxième polarisations orthogonales entre elles, les deux voies étant reliées à la sonde associée (Sᵢ), des moyens de pondération étant prévus pour pondérer chacune des deux première et deuxième voies (710) en amplitude et en phase.

9. Système suivant l'une quelconque des revendications 1 à 8, **caractérisé en ce que** l'antenne test (300) est reliée à l'autre des première et deuxième unités (410, 400) de manière filaire par l'intermédiaire d'au moins un câble (330).

10. Système suivant l'une quelconque des revendications 1 à 8, **caractérisé en ce que** l'antenne test (300) est reliée sans fil à l'autre des première et deuxième unités (410, 400) par l'intermédiaire d'au moins une liaison radio avec un émetteur et/ou récepteur embarqué (320).

11. Système suivant l'une quelconque des revendications précédentes, **caractérisé en ce que** le dispositif de commutation (100) est placé entre l'émulateur (600) de canaux et le réseau (200) de sondes (Sᵢ).

12. Procédé de simulation d'environnements électromagnétiques à l'aide d'un système (1) suivant l'une quelconque des revendications précédentes, le système comportant un réseau (200) d'une pluralité de sondes (Sᵢ) d'émission et/ou de réception de rayonnements électromagnétiques vers ou depuis un point test distant des sondes (Sᵢ) pour tester au moins une antenne test (300) située au point test, une multiplicité de canaux (C) de liaison des sondes à un émulateur (600) de canaux, une première unité (400) d'émission de signal, une deuxième unité (410) de réception de signal, l'une des première et deuxième unités (400, 410) étant reliée à l'émulateur (600) de canaux,
**caractérisé en ce que**
- on place le dispositif de commutation (100) dans la deuxième position d'étalonnage des canaux (C), dans laquelle le dispositif de commutation (100) relie l'émulateur (600) à l'autre des première et deuxième unités (410, 400) via le au moins un canal associé (C) sans passer par le réseau (200) de sondes (Sᵢ),
- on acquiert dans la deuxième position d'étalonnage des canaux (C ) la valeur d'un coefficient de transmission complexe sur chaque canal (C) entre la première unité (400) d'émission de signal et la deuxième unité (410) de réception de signal en passant par l'émulateur (600) de canaux sans passer par le réseau (200) de sondes (Sᵢ),
- puis on place le dispositif de commutation (100) dans la première position de mesure, dans laquelle le dispositif de commutation (100) relie l'émulateur (600) à respectivement au moins l'une (Sᵢ) des sondes via le au moins un canal associé (C) et relie l'autre des première et deuxième unités (410, 400) à l'antenne test (300),
- on teste l'antenne test (300) dans la première position de mesure en envoyant au moins un signal de la première unité (400) d'émission de signal à la deuxième unité (410) de réception de signal via ledit au moins un canal (C) par ladite au moins une sonde (Sᵢ) et en appliquant au signal une correction calculée en fonction au moins de la valeur ayant été acquise du coefficient de transmission complexe sur ledit au moins un canal (C).

13. Procédé suivant la revendication 12, **caractérisé en ce que** la correction est calculée en fonction au moins de la valeur ayant été acquise du coefficient de transmission complexe sur ledit au moins un canal (C) et en outre en fonction de paramètres de transmission ayant été mesurés au préalable sur le dispositif.

## Patentansprüche

1. System zur Simulation elektromagnetischer Umgebungen, mit:
- einer Anordnung (200) mit mehreren Sende- und/oder Empfangssonden (Sᵢ), die elektromagnetische Strahlen zu einem in einem Abstand von den Sonden (Sᵢ) angeordneten Testpunkt hin senden und/oder von diesem herkommend empfangen, um mindestens eine an dem Testpunkt angeordnete Testantenne (300) zu testen,
- mehreren Verbindungskanälen (C) zur Verbindung der Sonden mit einem Kanalemulator (600),
- einer ersten Signalsendeeinheit (400),
- einer zweiten Signalempfangseinheit (410),
wobei eine der ersten und zweiten Einheit (400,410) mit dem Kanalemulator (600) verbunden ist,
**gekennzeichnet durch** eine Schaltvorrichtung (100) mit einer ersten Messposition, in welcher die Schaltvorrichtung (100) den Emulator (600) mit jeweils mindestens einer (Sᵢ) der Sonden über den mindestens einen zugehörigen Kanal (C) verbindet und die jeweils andere Einheit der ersten und zweiten Einheit (410,400) mit der Testantenne (300) verbindet, und mit einer zweiten Kanaleichungsposition, in welcher die Schaltvorrichtung (100) den Emulator (600) mit der anderen der ersten und zweiten Einheit (410,400) über den mindestens einen zugehörigen Kanal (C) verbindet, unter Umgehung der Anordnung (200) der Sonden (Sᵢ), wobei sich die zweite Position von der ersten Position unterscheidet.

2. System nach Anspruch 1, **dadurch gekennzeichnet, dass** der Kanalemulator (600) mit der ersten Signalsendeeinheit (400) verbunden ist, die Schaltvorrichtung (100) in der ersten Messposition den Emulator (600) mit jeweils mindestens einer (Sᵢ) der Sonden über den mindestens einen zugehörigen Kanal (C) verbindet und die zweite Signalempfangseinheit (410) mit der Testantenne (300) verbindet und die Schaltvorrichtung (100) in der zweiten Kanaleichungsposition den Emulator (600) mit der zweiten Signalempfangseinheit (410) über den mindestens einen zugehörigen Kanal (C) verbindet, unter Umgehung der Anordnung (200) der Sonden (Sᵢ).

3. System nach Anspruch 1, **dadurch gekennzeichnet, dass** der Kanalemulator (600) mit der zweiten Signalempfangseinheit (410) verbunden ist, die Schaltvorrichtung (100) in der ersten Messposition den Emulator (600) mit jeweils mindestens einer (Sᵢ) der Sonden über den mindestens einen zugehörigen Kanal (C) verbindet und die erste Signalsendeeinheit (400) mit der Testantenne (300) verbindet und die Schaltvorrichtung (100) in der zweiten Kanaleichungsposition den Emulator (600) mit der ersten Signalsendeeinheit (400) über den mindestens einen zugehörigen Kanal (C) verbindet, unter Umgehung der Anordnung (200) der Sonden (Sᵢ).

4. System nach einem der vorstehenden Ansprüche, **dadurch gekennzeichnet, dass** die Schaltvorrichtung (100) in der ersten Messposition mehrere Zugänge (A) des Emulators (600) mit jeweils den mehreren Sonden (Sᵢ) über die mehreren zugehörigen Kanäle (C) verbindet und die andere der ersten und zweiten Einheit (410,400) mit der Testantenne (300) verbindet und die Schaltvorrichtung (100) in der zweiten Kanaleichungsposition die mehreren Zugänge (A) des Emulators (600) mit der anderen der ersten und zweiten Einheit (410,400) über die mehreren zugehörigen Kanäle (C) verbindet, unter Umgehung der Anordnung (200) der Sonden (Sᵢ), wobei sich die zweite Position von der ersten Position unterscheidet.

5. System nach einem der vorstehenden Ansprüche, **dadurch gekennzeichnet, dass** der Kanalemulator (600) steuerbare Wandlereinrichtungen (T) aufweist, um für jeden Kanal (C) die Frequenz und/oder die Phase und/oder die Amplitude und/oder die Polarisationen des Signals jeder zugehörigen Sonde (Sᵢ) einzeln zu ändern.

6. System nach einem der vorstehenden Ansprüche, **dadurch gekennzeichnet, dass** es Mittel (116,122,135) zur Steuerung der Schalteinrichtung (100) aufweist, um die Schalteinrichtung zwischen der einen und der anderen der ersten und zweiten Position wechseln zu lassen und in einer der ersten und zweiten Position zu halten.

7. System nach einem der vorstehenden Ansprüche, **dadurch gekennzeichnet, dass** die Schalteinrichtung (100) Schalter oder dergleichen (11,13) aufweist, die diese Positionen haben, um die Verbindungen sicherzustellen.

8. System nach einem der vorstehenden Ansprüche, **dadurch gekennzeichnet, dass** es eine Einheit (700) zur Erzeugung von zwei zueinander orthogonalen ersten und zweiten Polarisationen aufweist, um das von dem mindestens einen Kanal (C) transportierte Signal in zwei erste und zweite Wege (710), die jeweils die zwei zueinander orthogonalen ersten und zweiten Polarisationen aufweisen, zu teilen, wobei die zwei Wege mit der zugehörigen Sonde (Sᵢ) verbunden sind, wobei Gewichtungsmittel vorgesehen sind, um jeden der zwei ersten und zweiten Wege (710) in der Amplitude und Phase zu gewichten.

9. System nach einem der Ansprüche 1 bis 8, **dadurch gekennzeichnet, dass** die Testantenne (300) über mindestens ein Kabel (330) drahtgebunden mit der anderen der ersten und zweiten Einheit (410, 400) verbunden ist.

10. System nach einem der Ansprüche 1 bis 8, **dadurch gekennzeichnet, dass** die Testantenne (300) drahtlos mit der anderen der ersten und zweiten Einheit (410,400) über mindestens eine Funkverbindung mit einem eingebauten Sender und/oder Empfänger (320) verbunden ist.

11. System nach einem der vorstehenden Ansprüche, **dadurch gekennzeichnet, dass** die Schaltvorrichtung (100) zwischen dem Kanalemulator (600) und der Anordnung (200) der Sonden (Sᵢ) angeordnet ist.

12. Verfahren zur Simulation elektromagnetischer Umgebungen mit Hilfe eines Systems (1) nach einem der vorstehenden Ansprüche, wobei das System aufweist:
eine Anordnung (200) mit mehreren Sende- und/oder Empfangssonden (Sᵢ), die elektromagnetische Strahlen zu einem in einem Abstand von den Sonden (Sᵢ) angeordneten Testpunkt hin senden und/oder von diesem herkommend empfangen, um mindestens eine an dem Testpunkt angeordnete Testantenne (300) zu testen,
mehrere Verbindungskanäle (C) zur Verbindung der Sonden mit einem Kanalemulator (600),
eine erste Signalsendeeinheit (400),
eine zweite Signalempfangseinheit (410),
wobei eine der ersten und zweiten Einheit (400,410) mit dem Kanalemulator (600) verbunden ist,
**gekennzeichnet durch**:
- Anordnen der Schaltvorrichtung (100) in der zweiten Kanaleichungsposition, in welcher die Schaltvorrichtung (100) den Emulator (600) mit der anderen der ersten und zweiten Einheit (410,400) über den mindestens einen zugehörigen Kanal (C) verbindet, unter Umgehung der Anordnung (200) der Sonden (Sᵢ),
- Gewinnen in der zweiten Kanaleichungsposition des Werts eines komplexen Übertragungskoeffizienten auf jedem Kanal (C) zwischen der ersten Signalsendeeinheit (400) und der zweiten Signalempfangseinheit (410) auf dem Weg über den Kanalemulator (600), unter Umgehung der Anordnung (200) der Sonden (Sᵢ),
- anschließendes Anordnen der Schaltvorrichtung (100) in der ersten Messposition, in welcher die Schaltvorrichtung (100) den Emulator (600) mit jeweils mindestens einer der Sonden (Sᵢ) über den mindestens einen zugehörigen Kanal (C) verbindet und die andere der ersten und zweiten Einheit (410,400) mit der Testantenne (300) verbindet,
- Testen der Testantenne (300) in der ersten Messposition **durch** Schicken mindestens eines Signals von der ersten Signalsendeeinheit (400) zur zweiten Signalempfangseinheit (410) über den mindestens einen Kanal (C) **durch** die mindestens eine Sonde (Sᵢ) und Anwenden einer Korrektur auf das Signal, wobei sich die Korrektur berechnet als Funktion zumindest desjenigen Werts des komplexen Übertragungskoeffizienten, der auf dem mindestens einen Kanal (C) gewonnen wurde.

13. Verfahren nach Anspruch 12, **dadurch gekennzeichnet, dass** sich die Korrektur berechnet als Funktion zumindest desjenigen Werts des komplexen Übertragungskoeffizienten, der auf dem mindestens einen Kanal (C) gewonnen wurde, und außerdem als Funktion von Übertragungsparametern, die vorab an der Vorrichtung gemessen wurden.

## Claims

1. A system for simulating electromagnetic environment, including:
a network (200) of a plurality of probes (Sᵢ) for emitting and/or receiving electromagnetic radiations to or from a test point at a distance from the probes (Sᵢ) in order to test at least one test antenna (300) located at the test point,
- a multiplicity of channels (C) for connecting the probes to a channel emulator (600),
- a first signal emitting unit (400),
- a second signal receiving unit (410),
- one of the first and second units (400, 410) being connected to the channel emulator (600),
**characterized by** a switching device (100) having a first measurement position, in which the switching device (100) connects the emulator (600) respectively to at least one (Sᵢ) of the probes via said at least one associated channel (C) and connects the other of the first and second units (410, 400) to the test antenna (300), and a second position for calibrating the channels (C), in which the switching device (100) connects the emulator (600) to the other of the first and second units (410, 400) via said at least one associated channel (C) without passing through the network (200) of probes (S₁), the second position being distinct from the first position.

2. The system according to claim 1, **characterized in that** the channel emulator (600) is connected to the first signal emitting unit (400), the switching device (100) in the first measurement position connects the emulator (600) respectively to at least one (Sᵢ) of the probes via said at least one associated channel (C) and connects the second signal receiving unit (410) to the test antenna (300), and the switching device (100) in the second position for calibrating the channels (C) connects the emulator (600) to the second signal receiving unit (410) via said at least one associated channel (C) without passing through the network (200) of probes (Sᵢ).

3. The system according to claim 1, **characterized in that** the channel emulator (600) is connected to the second receiving unit (410), the switching device (100) in the first measurement position connects the emulator (600) respectively to at least one (Sᵢ) of the probes via said at least one associated channel (C) and connects the first signal emitting unit (400) to the test antenna (300), and the switching device (100) in the second position for calibrating the channels (C) connects the emulator (600) to the first emitting unit (400) via said at least one associated channel (C) without passing through the network (200) of probes (Sᵢ).

4. The system according to any of the preceding claims, **characterized in that** the switching device (100) in the first measurement position connects a multiplicity of accesses (A) of the emulator (600) respectively to the plurality of the probes (Sᵢ) via the multiplicity of the associated channels (C) and connects the other of the first and second units (410, 400) to the test antenna (300), and the switching device (100) in the second position for calibrating the channels (C) connects the multiplicity of accesses (A) of the emulator (600) to the other of the first and second units (410, 400) via the multiplicity of the associated channels (C) without passing through the network (200) of probes (Sᵢ), the second position being distinct from the first position.

5. The system according to any of the preceding claims, **characterized in that** the channel emulator (600) has controllable transformation means (T) for individually varying for each channel (C) at least one parameter from frequency, phase, amplitude and polarizations of the signal of each associated probe (Sᵢ).

6. The system according to any of the preceding claims, **characterized in that** it includes means (116, 122, 135) for controlling the switching device (100) for having it pass between both of the first and second positions and for maintaining it in any of the first and second positions.

7. The system according to any of the preceding claims, **characterized in that** the switching device (100) includes switches or the like (11, 13) having said positions for ensuring said connections.

8. The system according to any of the preceding claims, **characterized in that** it comprises a unit (700) for generating two first and second polarizations orthogonal to each other in order to divide the signal conveyed by said at least one channel (C) into two first and second routes (710) having both first and second polarizations orthogonal to each other, respectively, both routes being connected to the associated probe (Sᵢ), weighting means being provided for weighting each of the two first and second routes (710) in amplitude and in phase.

9. The system according to any of claims 1 to 8, **characterized in that** the test antenna (300) is connected to the other of the first and second units (410, 400) through wiring via at least one cable (330).

10. The system according to any of claims 1 to 8, **characterized in that** the test antenna (300) is connected wirelessly to the other of the first and second units (410, 400) via at least one radio link with an on-board emitter and/or receiver (320).

11. The system according to any of the preceding claims, **characterized in that** the switching device (100) is placed between the channel emulator (600) and the network (200) of probes (Sᵢ).

12. A method for simulating electromagnetic environments by means of a system (1) according to any of the preceding claims, the system including a network (200) of a plurality of probes (Sᵢ) for emitting and/or receiving electromagnetic radiations to or from a test point at a distance from the probes (Sᵢ) in order to test at least one test antenna (300) located at the test point, a multiplicity of channels (C) for connecting the probes to a channel emulator (600), a first signal emitting unit (400), a second signal receiving unit (410), one of the first and second units (400, 410) being connected to the channel emulator (600),
**characterized in that**
- the switching device (100) is placed in the second position for calibrating the channels (C), in which the switching device (100) connects the emulator (600) to the other of the first and second units (410, 400) via said at least one associated channel (C) without passing through the network (200) of probes (Sᵢ),
- in the second position for calibrating the channels (C) the value of a complex transmission coefficient is acquired on each channel (C) between the first signal emitting unit (400) and the second signal receiving unit (410) while passing through the channel emulator (600) without passing through the network (200) of probes (Sᵢ),
- the switching device (100) is then placed in the first measurement position, in which the switching device (100) connects the emulator (600) respectively to at least one (Sᵢ) of the probes via said at least one associated channel (C) and connects the other of the first and second units (410, 400) to the test antenna (300),
- the test antenna (300) is tested in the first measurement position by sending at least one signal from the first signal emitting unit (400) to the second signal receiving unit (410) via said at least one channel (C) through said at least one probe (Sᵢ) and by applying to the signal a correction calculated according to at least the value having been acquired from the complex transmission coefficient on said at least one channel (C).

13. The method according to claim 12, **characterized in that** the correction is calculated according to at least the value having been acquired from the complex transmission coefficient on said at least one channel (C) and further according to transmission parameters having been measured beforehand on the device.
